Europäisches Patentamt

European Patent Office

Office européen des brevets

(11) Publication number: **0 233 791**
**A2**

(12) # EUROPEAN PATENT APPLICATION

(21) Application number: **87301545.7**

(22) Date of filing: **23.02.87**

(51) Int. Cl.⁴: **H 01 L 21/28**
**H 01 L 29/78, H 01 L 29/08,**
**H 01 L 29/04**

(30) Priority: **21.02.86 IT 1951186**

(43) Date of publication of application:
**26.08.87 Bulletin 87/35**

(84) Designated Contracting States: **DE FR GB NL**

(71) Applicant: **SGS Microelettronica SpA**
**Via C. Olivetti, 2**
**I-20041 Agrate Brianza (MI) (IT)**

(72) Inventor: **Polignano, Maria Luisa**
**V. le Casiraghi, 205**
**I-20099 Sesto san Giovanni Milan (IT)**

(74) Representative: **Robinson, John Stuart et al**
**MARKS & CLERK 57/60 Lincoln's Inn Fields**
**London WC2A 3LS (GB)**

(54) Insulated gate field effect transistor and method of manufacture thereof.

(57) A methos is provided for the production of insulated gate field effect transistors with zero-depth junctions by planar processing. A layer of polycrystalline silicon (14) is formed above a predetermined area of a monocrystalline silicon substrate (1) and defines the source (16) and drain (17) regions of an insulated gate field effect transistor which are self aligned with the gate electrode (9). Subsequently, a layer (15) of material is formed for reducing the differences in depth in the underlying layer of polycrystalline silicon. The materials of the two layers (14,15) are then non-selectively etched until polycrystalline silicon regions are obtained which are insulated from the insulator (13) which surrounds the gate electrode (9) and which formed the source and drain regions of the transistor.

## Description

INSULATED GATE FIELD EFFECT TRANSISTOR AND METHOD OF MANUFACTURE THEREOF

The present invention relates to insulated gate field effect transistors (IGFET) and to a method which may be used for producing an IGFET with a high speed of response in high density integrated circuits.

In order to obtain high integration densities and high speeds of response, it is necessary to reduce both the horizontal and the vertical dimensions of IGFETs ("scaling principle"). It is, in particular, necessary to decrease the depth of the drain and source junctions in the substrate. However, in conventional commercially available IGFETs, the use of very thin junctions increases the layer resistance of the active regions and decreases the reliability of the contacts between these regions and the corresponding electrodes.

In order to remedy the above drawbacks, it has been proposed to produce an IGFET having its active source and drain regions formed above the surface of the substrate rather than inside it. A structure of this type may be obtained by selective epitaxy (as disclosed for example, in Italian Patent Application 21968 A/84 in the name of the present applicants) but this requires the use of reactors able to cause the growth in a reproducable manner of extremely thin epitaxial layers (of a thickness of approximately 1μm or less). These reactors exist but are very costly. In the above-mentioned patent application, a variant of the method is also disclosed in which the active source and drain regions are not obtained by epitaxial growth, but by recrystallization by laser of a deposited layer of polycrystalline silicon. Operations involving recrystallization by laser are not, however, advantageous for large-scale industrial applications.

According to a first aspect of the invention, there is provided a method of producing an insulated gate field effect transistor on a first predetermined area of a substrate of semiconductor material having a first type of conductivity, comprising the steps of: forming a first insulating layer on at least a second predetermined area of the substrate completely enclosing the first predetermined area; forming on a first region of the first predetermined area a second insulating layer; forming above the second insulating layer a conducting layer; forming above the conducting layer a third insulating layer, the second insulating layer and the conducting layer being arranged to form a gate dielectric and a gate electrode of the transistor, respectively; and forming insulating walls at least on the exposed portions of the edges of the conducting layer so that regions are formed in the first predetermined area which are not covered by any layer and which are separated, characterised by comprising the steps of: forming a layer of semiconductor material at least in the area of the first predetermined area and the second predetermined area; forming on the semiconductor material a layer of material for reducing the differences in depth of the underlying layer; non-selectively etching both the layer of material for reducing the depth differences of the underlying layer and the layer of semiconductor material until at least part of the first insulating layer and the third insulating layer are exposed so as to define portions of semiconductor material layer which are separate for forming source and drain regions of the transistor; implanting impurities for forming a second type of conductivity opposite to the first in the portions and of the layer of semiconductor material.

According to a second aspect of the invention, there is provided a method of producing an insulated gate field effect transistor on a first predetermined area of a substrate of semiconductor material having a first type of conductivity, comprising the steps of: forming a first insulating layer on at least a second predetermined area of the substrate completely enclosing the first predetermined area; forming on a first region of the first predetermined area a second insulating layer; forming above the second insulating layer a first conducting layer; forming above the first conducting layer a third insulating layer, the second insulating layer and the first conducting layer being arranged to form a gate dielectric and a gate electrode of the transistor, respectively; and forming insulating walls at least on the exposed portions of the edges of the conducting layer so that regions are formed in the first predetermined area which are not covered by any layer and which are separated, characterised by comprising the steps of: forming a second conducting layer at least in the area of the first predetermined area and the second predetermined area; forming on the second conducting layer a layer of material for reducing the differences in depth of the underlying layer; and non-selectively etching both the layer of material for reducing the depth differences of the underlying layer and the second conducting layer until at least part of the first insulating layer and the third insulating layer are exposed so as to define transistor source and drain regions in the remaining portion of the second conducting layer.

According to a third aspect of the invention, there is provided an insulated gate field effect transistor, comprising a substrate of semiconductor material of a first type of conductivity, source and drain regions of semiconductor material of a second type of conductivity opposite to the first, and an insulated gate between the source and drain regions, characterised in that the source and drain regions are provided by polycrystalline semiconductor material deposited on a surface of the substrate.

According to a fourth aspect of the invention, there is provided a method of making an insulated gate field effect transistor, comprising forming an insulated gate on a substrate of semiconductor material of a first type of conductivity, characterised in that source and drain regions of polycrystalline semiconductor material of a second type of conductivity opposite the first are formed on the substrate.

It is thus possible to provide a method of making insulated gate field effect transistors with junctions whose depth is, in practice, zero, which method is simpler to carry out than known methods.

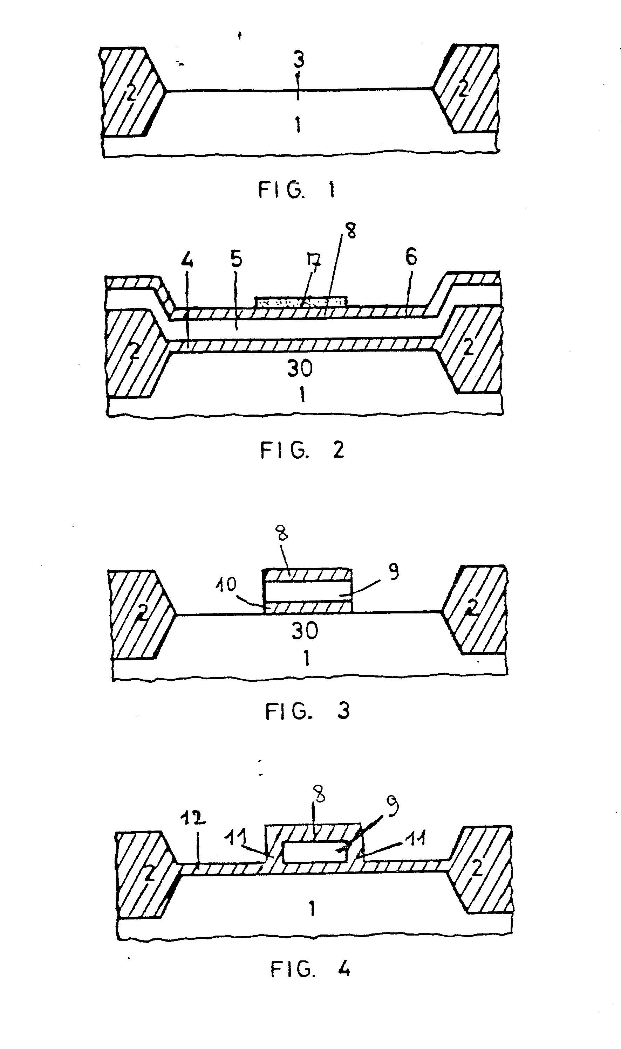

The invention will be further described, by way of example, with reference to the accompanying drawings, in which Figures 1 to 9 show vertical sections, to a greatly enlarged scale, through an IGFET transistor at different stages of a method of its production.

The initial structure shown in Figure 1 is obtained by operations known to persons skilled in the art and comprises a substrate 1 of monocrystalline silicon of p type, having a low concentration of doping impurities (approximately $10^{15}$ atoms/cm$^3$), in which a predetermined region 3 for receiving the IGFET is identified. Outside of the region 3 the substrate is covered by a layer 2 of silicon dioxide (SiO$_2$) which forms a field dielectric for insulating this active zone from other zones.

With reference to Figure 2, the following operations are than carried out in succession on this structure:

- heat oxidation, at a temperature of approximately 1000°C, of the exposed surface of the substrate 1 to form a layer 4 of silicon dioxide having a thickness of approximately 300 Å for forming the gate dielectric of the final transistor;

- deposition using silane (siH$_4$) of a layer 5 of polycrystalline silicon having a thickness of approximately 5000 Å. Deposition is carried out by the CVD (Chemical Vapour Deposition) technique at a temperature of approximately 600°C.

- doping of the layer 5 of polycrystalline silicon by the prior deposition of phosphorus oxychloride POC1$_3$) at a temperature of approximately 920°C. The concentration of doping impurities (of n type, for example phosphorus atoms) is approximately $10^{20}$ atoms/cm$^3$;

- diffusion of the doping impurities in the layer 5 of polycrystalline silicon and the growth of a thin layer 6 of silicon dioxide having a thickness of some hundreds of Å by exposure in an oxidising atmosphere to a temperature of approximately 1000°C (this layer of silicon dioxide grown on the polycrystalline silicon facilitates the subsequent operation);

- formation, by known photolithographic operations, of a photoresist mask 7 which protects a portion 8 of the layer 6 of silicon dioxide. This mask defines a predetermined gate area of the IGFET disposed above a region 30 of the substrate for the channel function of the transistor;

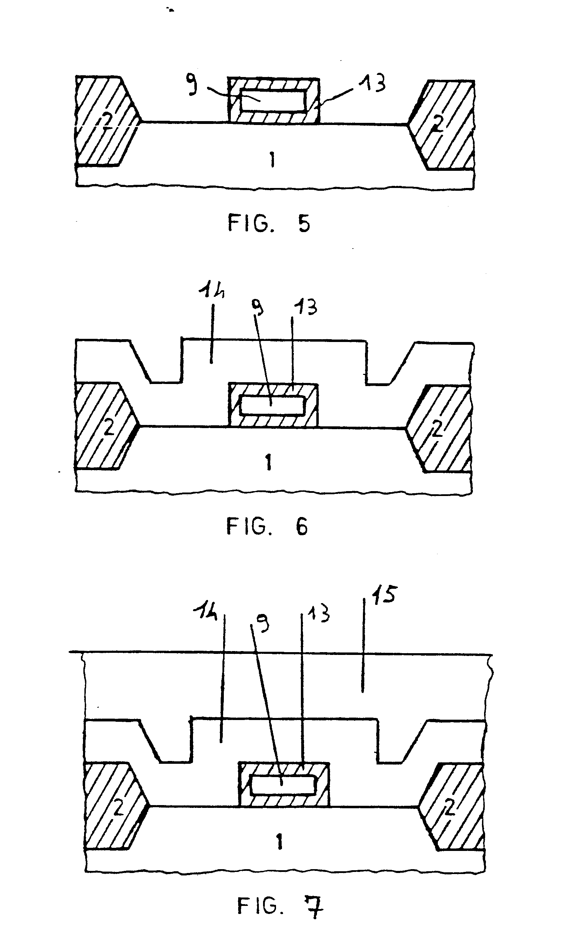

In addition, Figure 3 illustrates the operation of:

- removal of the unprotected parts of the layers 6, 5, 4 by successive selective chemical or physical etching (wet etching or plasma etching) so as to define a portion 8 of silicon dioxide, a portion 9 of polycrystalline silicon, and a portion 10 of gate oxide (definition of the gate) superimposed on one another in this predetermined area.

Figures 4, 5 and 6 illustrate the operations of:

- heat oxidation of the silicon surfaces exposed in this way: this oxidation is carried out at a comparatively low temperature of approximately 800°C to cause the growth of a layer of oxide whose thickness depends on the concentration of doping impurities in the silicon; a layer 11 of silicon dioxide having a thickness of approximately 1500 Å may thus grow on the edges and the surface of the portion 9 of polycrystalline silicon in which the concentration of doping agent is approximately $10^{20}$ atoms/cm$^3$, while a layer 12 of silicon dioxide having a thickness of approximately 350 Å grows on the exposed area of the substrate 1 in which the doping agent concentration is approximately $10^{15}$ atoms/cm$^3$;

- etching of the silicon oxide until the layer 12 is completely removed exposing the surface of the substrate 1 where the oxide layer is thinner (for example by diluted hydrofluoric acid). This etching does not expose the portion 9 of polycrystalline silicon as it is covered by a much thicker oxide; the portion 9 of polycrystalline silicon, which forms the gate electrode of the IGFET, is thus completely surrounded by the silicon dioxide 13 (Figure 5); the thickness of the field oxide 2 is not subject to a signficiant reduction;

- deposition of a layer 14 of polycrystalline silicon of a predetermined thickness using the CVD technique in conditions similar to those of the operation undertaken for the deposition of the layer 5.

This is followed by the following operations:

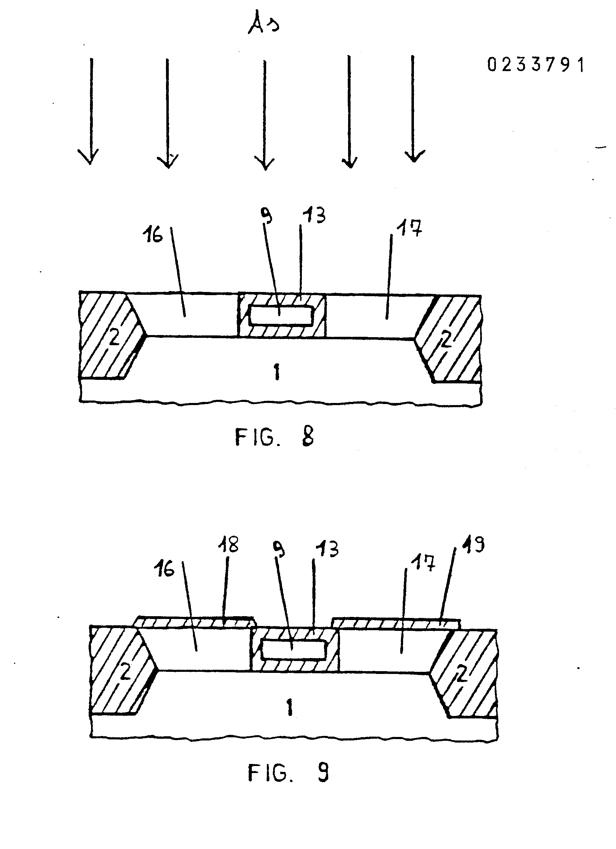

- deposition of a layer 15 of photoresist having a thickness, as shown in Figure 7, such as to reduce or cancel out the double step in the layer 14 between the gate area and the field area (Figure 7). This may be achieved, for example, by dimensioning the thickness of the layer of photoresist such that it is slightly greater than the width of the hollow between the two steps, the dimensions of which currently vary using conventional technologies around a micron. particular types of photoresist or particular conditions of deposition or setting of the photoresist may be more advantageous than others for this operation. As an alternative to photoresist, use may also be made of any other material with the property of reducing the depth differences, and which is therefore able to fill in the underlying hollows while simultaneously keeping the surface of the layer fairly uniform (for example doped silicon dioxide deposited by CVD techniques);

- etching of a non-selective type between the photoresist and polycrystalline silicon: this and the previous operation are designed to eliminate the double step and are therefore conventionally known overall as "planar processing" by persons skilled in the art. Non-selective etching is etching whose speed is in practice independent of the nature of the layer being etched: this etching, typically of the plasma type, is continued until both the silicon dioxide 13 and the field oxide 2 are exposed as shown in Figure 8. In this way two separate portions of polycrystalline silicon 16 and 17 are obtained from the layer of polycrystalline silicon 14, above the substrate at the side of the gate layers. These portions of polycrystalline silicon are used to form the source and drain regions of the field effect transistors;

- removal by plasma of any residual photoresist;

- ion implantation of n type doping impurities, for example arsenic (As) in the regions 16 and l7 defined as the remaining portions of the layer 14 of polycrystalline silicon. Implantation is carried out at low energy (approximately 80 KeV) so that the doping impurities penetrate only weakly up to a depth of approximately 1000 Å in the polycrystalline silicon. The dosage of doping impurities implanted is very high, approximately $5 \cdot 10^{15}$ atoms/cm$^2$, to obtain a high conductivity (alternatively the dopinq impurities may be implanted before the deposition of the photoresist layer):

- exposure in an oxidising atmosphere to a temperature of approximately 1000°C for a time sufficient to enable the diffusion of the implanted doping agent to a depth of approximately 5000 Å and the growth of a layer of silicon dioxide of a thickness of approximately 1000 Å above the regions 16 and 17 of polycrystalline silicon;

- the operations described above are followed by the normal operations for the opening of windows for the gate, source and drain contacts, for the formation of the relevant electrodes such as 18 and 19 (Figure 9) and finally for the passivation of the device.

In the above-described method, the doping agent is not implanted very deeply in the polycrystalline silicon regions 16 and 17 so that the subsequent high temperature heat treatments do not cause the diffusion of the doping agent in the substrate 1, and the source and drain junctions do not therefore fall below the gate oxide-substrate interface. In this situation, lateral junctions are not possible. The lack of this possibility makes it possible to obtain high speeds of response for the transistor. In addition the depleted zones, rather than extending laterally as in conventional IGFETs, extend vertically under the active regions which increases the effective length of the transistor and reduces the risk of punch-through.

The use of "planar processing" makes it possible to obtain source and drain regions self-aligned with the gate region and having junction depths which may be as small as desired by means of a method which does not require equipment other than that required for the production of a transistor of conventional type.

In addition, source and drain regions with thicknesses greater than the typical thicknesses of conventional methods are produced; this has the result that there is no deterioration in the layer resistance of the source and drain, even though this layer is formed by polycrystalline silicon. The polycrystalline silicon is also deposited at a relatively low temperature and does not therefore raise the problems (due to the diffusion of the doping agents) which might take place in a method requiring epitaxy.

The invention may also be applied to any type of MOS or CMOS process.

**Claims**

1. A method of producing an insulated gate field effect transistor on a first predetermined area of a substrate (1) of semiconductor material having a first type of conductivity, comprising the steps of: forming a first insulating layer (2) on at least a second predetermined area of the substrate (1) completely enclosing the first predetermined area; forming on first region of the first predetermined area a second insulating layer (10; forming above the second insulating layer a conducting layer (9); forming above the conducting layer a third insulating layer (8), the second insulating layer (10) and the conducting layer (9) being arranged to form a gate dielectric and a gate electrode of the transistor, respectively; and forming insulating walls at least on the exposed portions of the edges of the conducting layer so that regions are formed in the first predetermined area which are not covered by any layer and which are separated, characterised by comprising the steps of: forming a layer of semiconductor material (14) at least in the area of the first predetermined area and the second predetermined area; forming on the semiconductor material a layer (15) of material for reducing the differences in depth of the underlying layer; non-selectively etching both the layer (15) of material for reducing the depth differences of the underlying layer and the layer (14) of semiconductor material until at least part of the first insulating layer (2) and the third insulating layer (8) are exposed so as to define portions (16 and 17) of semiconductor material layer (14) which are separate for forming source and drain regions of the transistor; and implanting impurities for forming a second type of conductivity opposite to the first in the portions (16) and (17) of the layer (14) of semiconductor material.

2. A method of producing an insulated gate field effect transistor on a first predetermined area of a substrate (1) of semiconductor material having a first type of conductivity, comprising the steps of: forming a first insulating layer (2) on at least a second predetermined area of the substrate (1) completely enclosing the first predetermined area; forming on a first region of the first predetermined area a second insulating layer (10); forming above the second insulating layer a first conducting layer (9); forming above the first conducting layer a third insulating layer (8), the second insulating layer (10) and the first conducting layer (9) being arranged to form a gate dielectric and a gate electrode of the transistor, respectively; and forming insulating walls at least on the exposed portions of the edges of the conducting layer so that regions are formed in the first predetermined area which are not covered by any layer and which are separated, characterised by comprising the steps of: forming a second conducting layer (14) at least in the area of the first predetermined area and the second predetermined area; forming on the second conducting layer a layer (15) of material for reducing the differences in depth of the underlying layer; and non-selectively etching both th layer (15) of material for reducing the depth differences of the underlying layer and the second conducting layer (14) until at least part of the first insulating layer (2) and the third insulating layer (8) are exposed so as to define transistor source and drain regions (16 and 17) in the remaining portion of the second conducting layer (14).

3. A method as claimed in claim 1, characterised in that the substrate (1) is a monocrystalline silicon substrate and the semiconductor layer (14) is a polycrystalline silicon layer.

4. A method as claimed in claim 2, characterised in that the substrate (1) is a monocrystalline silicon substrate and the second conducting layer (14) is a layer of polycrystalline silicon heavily doped with impurities.

5. An insulated gate field effect transistor made by a method as claimed in any one of the preceding claims.

6. An insulated gate field effect transistor, comprising a substrate of semiconductor material of a first type of conductivity, source and drain regions of semiconductor material of a second type of conductivity opposite to the first, and an insulated gate between the source and drain regions, characterised in that the source and drain regions (16,17) are provided by polycrystalline semiconductor material deposited on a surface of the substrate (1).

7. A method of making an insulated gate field effect transistor, comprising forming an insulated gate on a substrate of semiconductor material of a first type of conductivity, characterised in that source and drain regions (16,17) of polycrystalline semiconductor material of a second type of conductivity opposite the first are formed on the substrate (1).

FIG. 1

FIG. 2

FIG. 3

FIG. 4

0233791

FIG. 5

FIG. 6

FIG. 7

As

0233791

16  9  13  17

2  2

1

FIG. 8

16  18  9  13  17  19

2  2

1

FIG. 9